# EUROPÄISCHE PATENTANMELDUNG

(11) **EP 0 866 480 A2**
(43) Veröffentlichungstag der Anmeldung: **23.09.1998**
(21) Anmeldenummer: 98103964.7
(22) Anmeldetag: 06.03.1998
(51) Int. Cl.: H01H 9/54

(54) **Verfahren zum Betreiben einer in einen Stromkreis geschalteten, elektrischen Last**

(30) Priorität: 20.03.1997 DE 19711622
(71) Anmelder: FRAUNHOFER-GESELLSCHAFT ZUR FÖRDERUNG DER ANGEWANDTEN FORSCHUNG E.V., 80636 München (DE)
(72) Erfinder: Konstanzer, Michael, Dipl.-Ing. (FH), 79114 Freiburg (DE); Freitag, Stefan, Dipl.-Ing. (FH), 79110 Freiburg (DE)

(57) **Zusammenfassung**

Die Erfindung bezieht sich auf ein Verfahren und eine Vorrichtung zum Betreiben einer in einen Stromkreis (2) geschalteten, elektrischen Last (3) über Kontakte (4) eines elektromagnetischen Schalters (5), zu dessen Kontakt(en) ein Halbleiterschalter (6) parallel geschaltet ist. Beim Ein-und Ausschalten ist der Halbleiterschalter und beim Betrieb ist der Kontakt (4) des elektromagnetischen Schalters (5) leitend.
Während des Betriebs wird bei geschlossenem Kontakt (4) des elektromagnetischen Schalters (5) der Halbleiterschalter (6) zumindest kurzzeitig gesperrt, so daß die an dem Kontakt (4) anstehende Spannung über den Spannungsabfall des leitenden Halbleiterschalters ansteigt und bei Überschreitung von beispielsweise 12 V eine eventuell vorhandene Oxydschicht durchbrochen und zerstört wird. Ein zuvor durch eine Oxydschicht nichtleitender, mechanischer Kontakt kann somit während des Betriebs "gereinigt" und wieder leitend gemacht werden.

## Beschreibung

Die Erfindung bezieht sich auf ein Verfahren zum Betreiben einer in einen Stromkreis geschalteten, elektrischen Last über Kontakte eines elektromagnetischen Schalters, zu dessen Kontakt(en) ein Halbleiterschalter parallel geschaltet ist, wobei beim Ein-und Ausschalten der Halbleiterschalter und beim Betrieb die Kontakte des elektromagnetischen Schalters leitend sind. Außerdem bezieht sich die Erfindung auf eine Vorrichtung zur Durchführung dieses Verfahrens.
Beim Schalten einer Last mittels Schützkontakten sind diese durch Abbrand und durch Lichtbögen bei Überströmen gefährdet. Dabei können sie auch verschweißen und nicht nur unbrauchbar werden, sondern auch gefährliche Betriebszustände herbeiführen, da im Fehlerfall bei verschweißten Kontakten ein Ausschalten nicht mehr möglich ist. Schütze werden deshalb überdimensioniert und wegen des vergleichsweise hohen Verschleißes häufig ausgetauscht.
Es sind auch kontaktlos arbeitende, elektronische Schütze oder Lastrelais bekannt, die aber für die zu erwartenden Kurzschlußströme überdimensioniert werden müssen. Außerdem brauchen solche elektronischen Schütze bei Strömen über einigen Ampere zusätzliche Kühlkörper. Elektronische Lastrelais oder Schütze sind üblicherweise für Spannungen bis zu 600 V und Strömen bis zu 120 A erhältlich. Nachteilig ist hierbei, daß durch den auftretenden Spannungsabfall eine nicht unerhebliche Verlustleistung und damit Wärme auftritt, die über Kühleinrichtungen abgeführt werden muß.

Es ist weiterhin bekannt, diesen elektronischen Lastrelais mechanische Schalter parallel zu schalten, um nach dem Einschalten durch das elektronische Lastrelais den Laststrom über mechanische Kontakte zu führen, um die Verlustleistung am elektronischen Lastrelais zu vermeiden. Somit wird die Wärmeentwicklung an den Halbleitern und der Lichtbogen beim Ausschalten an den Schützkontakten unterbunden.

Aus der P 41 32 208 ist ein solches Parallelschalten eines Relaiskontaktes zu einem elektronischen Schalter bekannt, wobei der elektronische Schalter nur zum Ende einer Netzspannungs-Halbwelle leitend gemacht wird und der Relais-Kontakt genau zur selben Zeit geschlossen wird. Dadurch ist eine Kurzschlußfestigkeit beim Einschalten und im Dauerbetrieb gewährleistet, weil für den elektronischen Schalter auch bei einem Ausgangskurzschluß nur eine geringe Belastung vorhanden ist und der mechanische Schalter aufgrund der geringen zu überbrückenden Spannung keinen Lichtbogen beim prellenden Schließen aushalten muß und somit nicht verschweißen kann. Der mechanische Kontakt wird dazu beim Ausschalten vor dem elektronischen Schalter geöffnet.
Es sind auch Kombinationen von mechanischen und elektronischen Schaltern bekannt, bei denen voreilende Kontakte des mechanischen Schalters ein Thyristorpaar leitend machen und die Hauptkontakte dieses Thyristorpaar brücken.
Weiterhin ist aus der DE 34 32 025 A1 ein Schaltgerät mit einem Hybrid-Schalter bekannt, bei dem zusätzlich zu einem elektronischen Festkörperschalter und einem dazu parallel geschalteten, elektromechanischem Schalter ein weiterer elektromechanischer Schalter vorgesehen ist, der in Reihe zu dem elektronischen Festkörperschalter geschaltet ist. Durch die beiden elektromechanischer Schalter in den beiden Parallelstrecken kann ein Verbraucher galvanisch von der Stromquelle getrennt werden.
In der Praxis hat es sich gezeigt, daß die Überbrückungskontakte nach einiger Zeit oxydieren können, so daß häufig unbemerkt, die Halbleiterschalter auch im normalen Betrieb den vollen Laststrom übernehmen und dann nach einiger Zeit zerstört werden, da sie nicht für diesen Laststrom im Dauerbetrieb dimensioniert beziehungsweise ausreichend gekühlt sind. Die Folge ist ein Ausfall der Geräte.

Aufgabe der vorliegenden Erfindung ist es, ein Verfahren und eine Vorrichtung zu schaffen, wobei die Lebensdauer der parallel geschalteten Schaltelemente - mechanische Kontakte und Halbleiterschalter - wesentlich erhöht ist und die Betriebssicherheit auch durch oxydierende Kontakte nicht beeinträchtigt wird.

Zur Lösung dieser Aufgabe wird hinsichtlich des Verfahrens vorgeschlagen, daß während des Betriebs bei geschlossenem Kontakt des elektromagnetischen Schalters zum Beseitigen eines durch einen gegebenenfalls erhöhten Kontaktübergangswiderstand verursachten erhöhten Spannungsabfalls über dem mechanischen Kontakt, die Ansteuerung des Halbleiterschalters zumindest kurzzeitig unterbrochen und damit der Halbleiterschalter bei erhöhtem Kontaktübergangswiderstand gesperrt und dadurch die Spannung am mechanischen Kontakt erhöht wird.
Durch diese Maßnahme wird insbesondere bei oxydierten und dann nicht mehr leitenden Kontakten erreicht, daß die an dem Kontakt anstehende Spannung über den Spannungsabfall des leitenden elektronischen Schalters ansteigt und daß bei Überschreitung von beispielsweise 20 V die Oxydschicht durchbrochen und zerstört wird.
Üblicherweise bleibt der Halbleiterschalter nach der Einschaltphase des Stromkreises weiterhin angesteuert und erst in der Ausschaltphase nach dem Öffnen der mechanischen Kontakte wird der Halbleiterschalter gesperrt. Ist der mechanische Kontakt in Ordnung, ist der Spannungsabfall über die parallel geschalteten Kontakte kleiner als die Schwellspannung am Halbleiterschalter, so daß auschließlich der mechanische Kontakt den Laststrom führt. Ein zum Beispiel nach einer längeren Ausschaltphase oxydierter und somit nichtleitender, mechanischer Kontakt kann aber den Laststrom nicht übernehmen, so daß in Folge dessen der Halbleiterschalter, der nur für die kurzzeitige Übernahme des Laststromes beim Ein- und Ausschalten dimensioniert ist, überlastet und zerstört wird.
Mit dem erfindungsgemäßen Verfahren kann zu vorgebbaren Zeitpunkten ein "Reinigen" der mechanischen Kontakte stattfinden und so Oxydschichten beseitigt und die Lebensdauer dadurch sowohl der mechanischen Kontakte als auch des Halbleiterschalters wesentlich verlängert und die Betriebssicherheit erhöht werden.

Zweckmäßigerweise ist bei einem wechselspannungsbeaufschlagten Stromkreis vorgesehen, daß die Sperrphase des Halbleiterschalters während des Betriebs bei geschlossenem Kontakt des elektromagnetischen Schalters mit einem Nulldurchgang der Wechselspannung gestartet und innerhalb einer Halbwelle, vorzugsweise innerhalb einer viertel Netzhalbwelle durch Ansteuerung des Halbleiterschalters beendet wird.
Diese vergleichsweise kurze Zeit von zum Beispiel etwa 2,5 ms bei einer Netzfrequenz von 50 Hz reicht aus, um die Spannung an dem durch Oxydation nicht mehr leitenden, mechanischen Kontakt auf einen Wert ansteigen zu lassen, der zum "Freibrennen" oder "Durchbrennen" der Oxydschicht ausreicht. Praktische Versuche haben gezeigt, daß eine am Kontakt anstehende Spannung von ca. 20 V zum Durchbrechen der Oxydschicht genügt.
Nach einer Weiterbildung der Erfindung ist vorgesehen, daß während des Betriebs bei gesperrtem Halbleiterschalter der Strom innerhalb des Stromkreises gemessen wird und daß nach dem Überschreiten eines vorgebbaren Stromes der Halbleiterschalter leitend geschaltet wird.
Das Durchbrechen der Oxydschicht wird dadurch überwacht und dieser Vorgang durch das Zuschalten des Halbleiterschalters in einer Phase beendet, in der der Kontakt leitfähig ist, andererseits aber die Spannung am Kontakt noch keinen so hohen Wert erreicht hat, daß der dann leitende Kontakt durch Abbrand beschädigt wird und/oder durch Funkenbildungen Störungen verursacht. Es ist somit eine exakt gesteuerte Oxydschichtentfernung möglich. Bei vollständig geschlossenem, mechanischem Kontakt könnte der Halbleiterschalter wieder abgeschaltet werden, da die Stromübernahme durch den intakten, mechanischen Kontakt erfolgt.
Auch bei induktiven Strömen innerhalb des Stromkreises ist das Messen des Stromes vorteilhaft, da der Sperrzeitpunkt des Halbleiterschalters in diesem Falle nach dem Nulldurchgang der Spannung liegen kann.
Durch die Strommessung wird auch mitüberwacht, ob die Spannungsbeaufschlagung des oxydierten, mechanischen Kontaktes zum Durchbrechen der Oxydschicht geführt hat.
Eine solche Kontrolle kann auch erfolgen, indem bei gesperrtem Halbleiterschalter der Spannungsabfall über dem geschlossenen Kontakt des elektromagnetischen Schalters nach einer vorgebbaren Zeit nach dem Sperren des Halbleiterschalters gemessen und bei Überschreiten eines vorgebbaren Wertes, der Stromkreis vorzugsweise unterbrochen und/oder eine Störungsmeldung abgegeben wird.
Zur Überwachung des mechanischen Kontaktes auf Funktionstüchtigkeit kann auch der Spannungsabfall über dem geschlossenen Kontakt des elektromagnetischen Schalters und dabei leitend geschaltetem Halbleiterschalter während des Betriebes überwacht und bei Überschreiten eines vorgebbaren Wertes, der Halbleiterschalter zumindest kurzzeitig gesperrt wird.
Wird dabei eine Spannung gemessen, die etwa der üblichen Schwellspannung des Halbleiterschalters entspricht, ist dies ein Zeichen dafür, daß der mechanische Kontakt nicht mehr leitet. Um eine eventuell vorhandene Oxydschicht zu beseitigen, kann der Kontakt dann durch kurzzeitiges Sperren des Halbleiterschalters mit erhöhter Spannung beaufschlagt werden, um die Oxydschicht zu durchbrechen. Führt dies nicht zum Erfolg, kann dieser Vorgang wiederholt oder der Stromkreis unterbrochen und eine Fehlermeldung ausgegeben werden, so daß eine Überlastung des Halbleiterschalters verhindert und der mechanische Kontakt rechtzeitig ausgewechselt werden kann.

Eine Ausgestaltung der Erfindung, für die selbständiger Schutz beansprucht wird, sieht vor, daß die Spannung zwischen Gate und Kathode des Halbleiterschalters, insbesondere von Thyristoren, nach einer vorgebbaren Zeit nach dem Sperren des Halbleiterschalters gemessen und bei Überschreiten eines vorgebbaren Wertes, der Stromkreis vorzugsweise unterbrochen und/oder eine Störungsmeldung abgegeben wird.
Die Überprüfung, ob der mechanische Kontakt stromführend ist oder nicht, kann damit auf besonders einfache Weise und bei niedrigem Spannungsniveau kontrolliert werden. Wenn der Halbleiterschalter den Laststrom übernimmt, ist für den Zeitpunkt der Netzhalbwelle eine Spannung von ca. 1 V am Steuergate gegen die Kathode zu messen, auch nachdem der Zündimpuls wieder vom Steuergate entfernt wurde. Nach dem Freibrennen ist dieses Signal jedoch nicht zu messen, da der Thyristor den Strom aufgrund seiner Schwellspannung dann nicht mehr trägt, wenn der mechanische Kontakt leitend ist. Eine Auswertung dieses Signales kann im Fehlerfalle zum sicheren Ausschalten führen, bevor der Halbleiterschalter oder die mechanischen Kontakte durch Überhitzung Schaden nehmen. Auch kann dann eine Alarmgabe nach außen erfolgen.
Für eine hohe Strombelastung können mehrere mechanische Kontakte zu einem Halbleiterschalter parallel geschaltet werden. Um auch hierbei ein Freibrennen oxydierter Einzelkontakte zu ermöglichen, ist vorgesehen, daß bei mehreren unabhängig aktivierbaren, elektromagnetischen Schaltern mit jeweils zueinander parallel geschalteten Kontakten währen des Betriebs bis auf einen der Kontakte alle übrigen Kontakte geöffnet und der Halbleiterschalter zumindest kurzzeitig gesperrt wird und daß nacheinander alle Einzelkontakte bei jeweils geöffneten anderen Kontakten durch kurzzeitiges Sperren des Halbleiterschalters belastet werden.
Die Kontrolle der einzelnen Kontakte auf Leitfähigkeit kann nacheinander erfolgen, wie bei einem Einzelkontakt. Dabei können die Einzelkontakte durch die unabhängige Betätigbarkeit nacheinander einzeln aktiviert werden.

Die Vorrichtung zum Betreiben einer elektrischen Last in einem Stromkreis, in dem sich wenigstens ein Kontakt eines elektromagnetischen Schalters befindet, zu dessen Kontakt ein Halbleiterschalter parallel geschaltet ist, wobei eine Ansteuerschaltung für den elektromagnetischen Schalter sowie den Halbleiterschalter vorgesehen ist, ist dadurch gekennzeichnet, daß die Ansteuerschaltung eine Zeitschalteinrichtung aufweist, zum zumindest kurzzeitigen Sperren des Halbleiterschalters während des Betriebs bei geschlossenem Kontakt des elektromagnetischen Schalters.
Mittels der Zeitschalteinrichtung oder dergleichen Steuereinrichtung kann der leitende Halbleiterschalter kurzzeitig gesperrt werden, so daß die Spannung am parallel geschalteten, geschlossenen, mechanischen Kontakt soweit ansteigen kann, daß eine eventuell vorhandene Oxydschicht durchbrochen wird und damit der mechanische Kontakt wieder funktionsfähig wird.
Zweckmäßigerweise beinhaltet die Ansteuerschaltung einen Mikrocontroller, wobei dieser zur Auswertung der Meßwerte mit wenigstens einem Stromsensor und/oder wenigstens einem Spannungssensor verbunden ist. Der Mikrocontroller kann dabei sowohl Steuer- als auch Meßaufgaben übernehmen, so daß eine kompakte Bauweise möglich ist.
Bevorzugt sind der Halbleiterschalter, das oder die elektromagnetischen Schalter, die Ansteuer- und Auswertschaltung und dergleichen Baugruppen, gegebenenfalls in Verbindung mit einer Sanfteinschalteinrichtung für induktive Lasten, in einer kompletten Baueinheit insbesondere als Hybrid-Schalter zusammengefaßt.
Bei einer solchen Baueinheit kann der Mikrocontroller bedarfsweise für alle Baugruppen verwendet werden, so daß der Aufwand vergleichsweise gering ist. Eine solche Baueinheit vereint die Vorteile elektromagnetischer Schalter mit denen der Halbleiterschalter und weist den besonderen Vorteil auf, daß die mechanischen Kontakte wesentlich länger betriebsbereit gehalten werden können und daß deren Funktionstüchtigkeit auch überwacht wird, so daß Folgefehler bei defekten Kontakten vermieden werden. Darüber hinaus ist der selbstüberwachende Schalter vorteilhaft mit einer Sanfteinschalteinrichtung kombinierbar, die in der Lage ist induktive Lasten ohne Einschaltstromstoß einzuschalten.

Zusätzliche Ausgestaltungen der Erfindung sind in den weiteren Unteransprüchen aufgeführt. Nachstehend ist die Erfindung mit ihren wesentlichen Einzelheiten anhand der Zeichnungen noch näher erläutert.

Es zeigt:
- Fig. 1: ein Blockschaltbild der erfindungsgemäßen Vorrichtung und
- Fig. 2-5: Diagrammfolgen für unterschiedliche Betriebszustände der erfindungsgemäßen Vorrichtung.

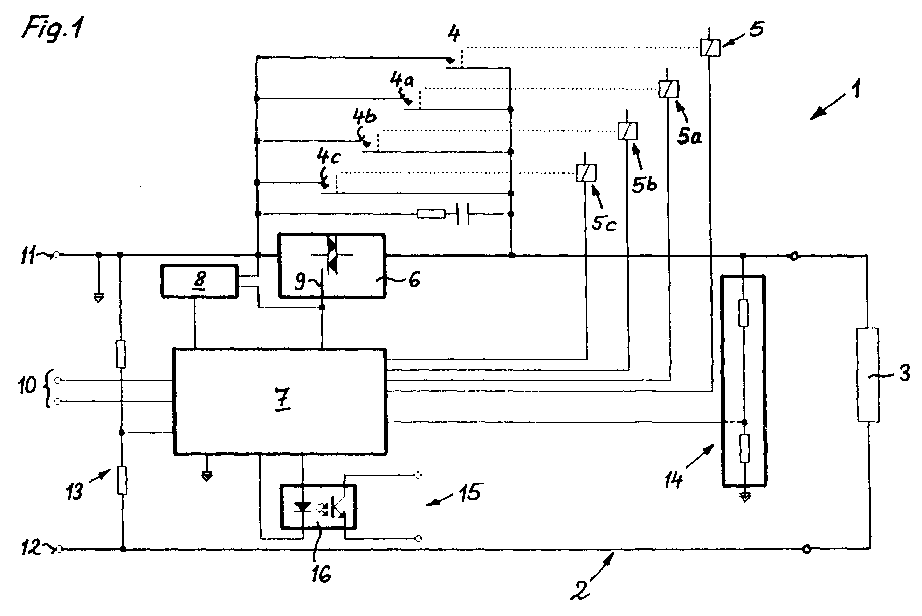

Eine in Fig. 1 gezeigte Vorrichtung 1 dient zum Betreiben einer in einen Stromkreis 2 geschalteten, elektrischen Last 3. Diese Last 3 kann über mechanische Kontakte sowie einen Halbleiterschalter 6 ein- und ausgeschaltet werden. Im Ausführungsbeispiel sind vier elektromagnetische Schalter 5 bis 5c vorgesehen, deren Kontakte 4 bis 4c zueinander und zu dem Halbleiterschalter 6 parallel geschaltet sind. Der Halbleiterschalter 6 kann ein Triac oder zwei antiparallel geschaltete Thyristoren sein.
Der Halbleiterschalter 6 und die elektromagnetischen Schalter 5 bis 5c werden von einem Mikrocontroller 7 angesteuert. Die vier elektromagnetischen Schalter mit ihren parallel geschalteten Einzelkontakten sind im Ausführungsbeispiel für eine entsprechend hohe Strombelastung vorgesehen. Beispielsweise kann ein Einzelkontakt 20 A Strom schalten. Im Ausführungsbeispiel ist somit eine Strombelastung von 80 A zulässig.
Der Halbleiterschalter 6 ist während der Einschaltphase und der Ausschaltphase aktiv und ist so dimensioniert, daß er den vollen Laststrom für kurze Zeit beispielsweise einige Sekunden übernehmen kann. Während des Einschaltvorganges wird zuerst der Halbleiterschalter 6 angesteuert und damit leitend und anschließend werden die elektromagnetischen Schalter aktiviert, deren Kontakte dann den Halbleiterschalter 6 überbrücken und den Laststrom übernehmen. Während des Kontaktiervorganges steht an den Kontakten nur die Schwellspannung des Halbleiterschalters 6, also etwa 1,5 V an, so daß die Belastung der Kontakte ganz erheblich reduziert ist und Störungen durch Funkenbildung vermieden werden. Durch die geschlossenen Kontakte wird der Spannungsabfall über dem Halbleiterschalter 6 kleiner als dessen Schwellspannung, so daß er nach dem Schließen der Kontakte inaktiv ist und keinen Strom führt. Der Halbleiterschalter kann dabei weiterhin angesteuert bleiben.
Beim Ausschaltvorgang läuft die Schaltfolge umgekehrt ab, indem zuerst die mechanischen Kontakte 4 bis 4c bei angesteuertem Halbleiterschalter 6 geöffnet werden und erst dann wird der Halbleiterschalter 6 gesperrt und damit der Stromkreis unterbrochen.
Würden der oder die Kontakte nicht sicher schließen, so würde der Halbleiterschalter 6 durch die auftretende Verlustleistung nach kurzer Zeit zerstört werden. Sind einzelne Kontakte bei mehreren parallel geschalteten Kontakten defekt, so tritt eine Überlastung an den übrigen, leitenden Kontakten auf, die ebenfalls mit der Zeit zur Zerstörung der Kontakte und infolge dessen auch des Halbleiterschalters 6 führt.
Bei Parallelschaltungen zwischen Halbleiterschalter und mechanischem Kontakt ist eine häufige Ausfallursache des mechanischen Kontaktes auf eine Oxydation seiner Kontaktflächen zurückzuführen. Da der mechanische Kontakt jeweils nur die Schwellspannung des Halbleiterschalters 6 schaltet, können Oxydschichten auf den Kontakten nicht durchdrungen werden, so daß auch bei mechanisch geschlossenem Kontakt eine Stromführung dann nicht zustande kommt.
Erfindungsgemäß wird vorgeschlagen, daß der Halbleiterschalter 6 während des Betriebs bei geschlossenem Kontakt des elektromagnetischen Schalters zumindest kurzzeitig gesperrt wird. Ausgehend von einem einzeln dem Halbleiterschalter 6 parallel geschalteten Kontakt, beispielsweise Kontakt 4, der wegen einer Oxydschicht auf seinen Kontaktflächen nicht leiten kann, wird zweckmäßigerweise während der Startphase nach dem Ansteuern des elektromagnetischen Schalters 5 kurzzeitig die Ansteuerung des Halbleiterschalters 6 unterbrochen, so daß an dem Kontakt 4 die volle, an den Stromkreis angelegte Speisespannung ansteht.
Versuche haben gezeigt, daß Spannungen um 20 V in der Lage sind, eine Oxydschicht auf den Kontaktflächen durch "Freibrennen" zu beseitigen. Um während dieses Freibrenn - oder Reinigungsvorganges keinen unnötigen Kontaktverschleiß zu verursachen und um auch Störungen durch Funkenbildung zu vermeiden, kann der Halbleiterschalter 6 nach sehr kurzer Zeit von einigen Millisekunden wieder leitend geschaltet werden, so daß die Spannung am Kontakt 4c begrenzt wird.

Sind mehrere mechanische Kontakte 4, 4a, 4b, 4c parallel geschaltet, so kann das Entfernen von Oxydschichten an einem oder mehreren der Kontakte dadurch erfolgen, daß bis auf den freizubrennenden, einzelnen Kontakt alle übrigen Kontakte geöffnet werden. In diesem Betriebszustand wird dann der Halbleiterschalter kurzzeitig gesperrt, so daß durch die hohe Spannungsbeaufschlagung der oxydierte Einzelkontakt leitend wird. Mit den anderen, parallel geschalteten Kontakten kann dann in gleicher Weise nacheinander verfahren werden. Zweckmäßig ist es, wenn dieses Verfahren nach jedem Einschaltvorgang oder nach einer vorgebbaren Anzahl von Einschaltvorgängen vorgenommen wird. Dadurch ist sichergestellt, daß während des Betriebes alle geschlossenen Kontakte Strom führen und der gesamte Laststrom entsprechend der Anzahl der Kontakte auch gleichmäßig verteilt ist.

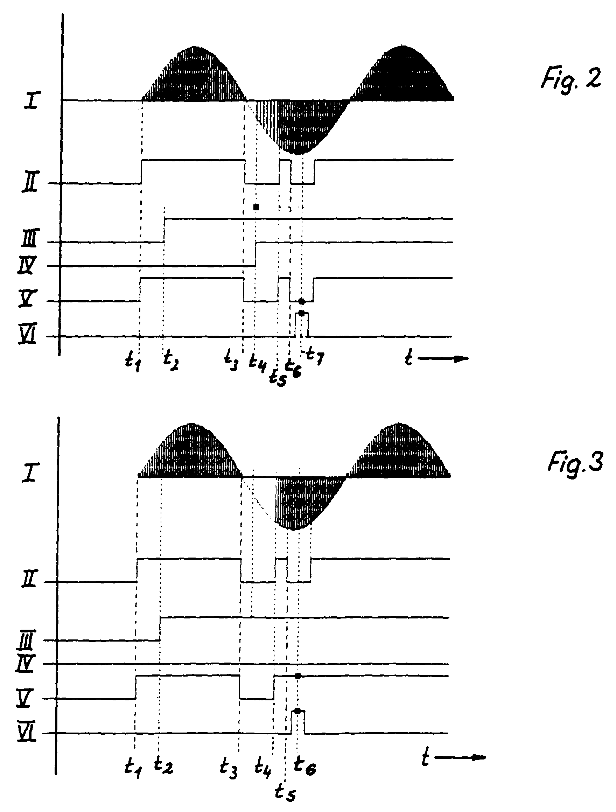

Mit Hilfe einer Meßeinrichtung 8 besteht die Möglichkeit der Kontrolle der einzelnen Kontakte 4 bis 4c. Prinzipiell erfolgt damit eine Überwachung, ob über den Halbleiterschalter 6 Strom fließt oder nicht. Daraus ist ein Rückschluß möglich, ob ein parallel geschalteter, mechanischer Kontakt die Stromführung übernommen hat oder nicht. Fließt über den Halbleiterschalter 6 bei angesteuertem Halbleiterschalter und gleichzeitig parallel geschlossenem, mechanischen Kontakt Strom, so ist davon auszugehen, daß der geschlossene mechanische Kontakt beispielsweise wegen Oxydation nicht leitet. Umgekehrt ist auch eine Überwachung auf Leitfähigkeit bzw. auch eine Kontrolle nach einem Freibrenn-Versuch möglich.
Im vorliegenden Fall erfolgt mit Hilfe der Meßeinrichtung 8 eine indirekte Strommessung, indem die Spannung zwischen Kathode und Steueranschluß 9 (Gate) gemessen wird. Wenn der bzw. die Thyristoren des Halbleiterschalters 6 Laststrom führen, ist zwischen Steueranschluß 9 und Kathode beim Ansteuern eine Spannung von ca. 1 V zu messen. Solange der Thyristor Strom führt, steht diese Spannung an, auch wenn keine Zündspannung an den Steueranschluß 9 angelegt ist. Somit ist auf einfache Weise und ohne Zusatz-Bauelemente eine Strommessung im Sinne einer Ja-Nein-Messung möglich.
Zur Auswertung ist die Meßeinrichtung 8 mit dem Mikrocontroller 7 verbunden. Dieser weist eingangsseitig noch zwei Anschlüsse 10 zum Einschalten auf. Weiterhin ist an den Netzeingang mit den Anschlußklemmen 11 und 12 ein Spannungsteiler 13 angeschlossen, dessen Teilerspannung bei einem Wechselstromnetz zur Synchronisation und zum Messen der Spannung vor dem Schalter dient.
Ein weiterer Spannungsteiler 14 dient zur Spannungsmessung am lastseitigen Ausgang und dient zur Erkennung von Schaltfehlern des Halbleiterschalters 6 wie beispielsweise eine Unterbrechung oder auch das Durchlegieren des Halbleiterschalters.
Schließlich ist an dem Mikrocontroller 7 noch ein Alarmausgang 15 vorgesehen, der im Ausführungsbeispiel über einen Optokoppler 16 entkoppelt ist.
Die erfindungsgemäße Vorrichtung bildet somit einen Hybridschalter mit Meßeinrichtung(en) zur Selbstdiagnose.
Die Funktionsweise der erfindungsgemäßen in Fig. 1 gezeigten Vorrichtung wird nachstehend anhand der Diagramme nach Fig. 2 bis 5 näher erläutert.
Jeder Figur sind mehrere Diagrammzeilen zugeordnet, die bei gleichen Funktionen auch mit gleichen, römischen Ziffern gekennzeichnet sind.
Die Diagrammzahlen I bis VI gem. Fig. 2 zeigen das Verfahren beim erfolgreichen Freibrennen eines zu einem Halbleiterschalter 6 parallel geschalteten Kontaktes zum Beispiel Kontakt 4. Der Stromkreis ist hier und den nachfolgenden Diagrammen an eine Netzwechselspannung mit einer Netzfrequenz von 50 Hz angeschlossen. Die Diagrammzeile I zeigt 1 1/2 Perioden der Netzwechselspannung. Bereiche, in denen Strom fließt sind mit einer Vertikalschraffur gekennzeichnet.
Die Betrachtung des Funktionsablaufes beginnt mit dem Zeitpunkt t₁. Dieser Zeitpunkt t₁ fällt mit dem Nulldurchgang der an die Last 3 geschalteten Netzspannung gemäß Diagrammzeile I zusammen. In diesem Nulldurchgang wird der Halbleiterschalter 6 angesteuert, so daß über ihn ein Stromfluß zur Last 3 zustande kommt. Innerhalb der nachfolgenden Halbwelle wird der elektromagnetische Schalter, dessen Kontakt z.B. 4 zum Halbleiterschalter 6 parallel geschaltet ist, betätigt und es erfolgt zum Zeitpunkt t₂ ein mechanischer Kontaktschluß gemäß Diagrammzeile III. Es wird im vorliegenden Fall davon ausgegangen, daß der mechanische Kontakt durch Oxidation auch im geschlossenen Zustand nicht leitfähig ist. Dies ist in der Diagrammzeiel IV verdeutlicht. Trotz mechanischem Kontaktschluß (Diagrammzeile III) zum Zeitpunkt t₂ erfolgt gemäß Diagrammzeile IV keine Stromübernahme durch den geschlossenen, mechanischen Kontakt.
Beim nächsten Nulldurchgang der Netzwechselspannung zum Zeitpunkt t₃ wird nun der Halbleiterschalter 6 nicht erneut angesteuert und bleibt somit gesperrt. Die Folge davon ist, daß die Netzwechselspannung, die an dem geschlossenen, aber nicht leitenden Kontakt ansteht, einen bestimmten Wert überschreitet, der zum Freibrennen der Oxydschicht an den Kontaktflächen ausreicht. Zum Zeitpunkt t₄ ist in der Diagrammzeile IV erkennbar, daß die Oxydschicht beseitigt ist und der Kontakt nun leitet. Da der Netzspannungseinbruch für die Last 3 beim Freibrennen des Kontaktes nur etwa 12V beträgt, tritt dies nicht störend in Erscheinung, zumal dies bei einer Netzspannung von 230 V einem in der Regel zulässigen Spannungseinbruch von etwa 5% gleichkommt.
Mit Hilfe der Meßeinrichtung 8 (Fig. 1) wird dann überprüft, ob das Beseitigen einer vorhandenen Oxydschicht an dem mechanischem Kontakt, durch entsprechende Spannungsbeaufschlagung, zum Erfolg geführt hat. Der Halbleiterschalter 6 wird dazu zum Zeitpunkt t₅ angesteuert und zum Zeitpunkt t₆ wird die Ansteuerung des Halbleiterschalters beendet.
Wie bereits anhand der Fig. 1 beschrieben, kann durch Spannungsmessung am Halbleiterschalter 6 überprüft werden, ob der Laststrom über den Halbleiterschalter oder den parallel geschalteten, mechanischen Kontakt fließt.
Erwähnt sei in diesem Zusammenhang noch, daß außer der indirekten Strommessung zwischen Steueranschluß 9 und Kathode des Halbleiterschalters auch direkt die Spannung über dem Halbleiterschalter bzw. damit auch über dem parallel geschalteten Kontakt erfaßt werden kann.
Die indirekte Strommessung über Kathode-Gate hat den Vorteil, daß hier nur Spannungen zwischen 0 und etwa 1 V auftreten, während bei direkter Spannungsmessung über dem Halbleiterschalter Spannungen zwischen 0 V und der vollen Netzspannung anstehen können.
Nach dem Zeitpunkt t₆, im vorliegenden Ausführungsbeispiel zum Zeitpunkt t₇, wo der Halbleiterschalter 6 bei geschlossenem Parallelkontakt nicht angesteuert ist, wird überprüft, ob über den Halbleiterschalter 6 Strom fließt oder nicht. Im vorliegenden Falle nach Fig. 2 wird gem. Diagrammzeile V zwischen Kathode und Gate des Halbleiterschalters keine Spannung gemessen. Demnach fließt durch den Halbleiterschalter 6 auch kein Strom. Dies resultiert aus der Stromübernahme durch den nun wieder leitenden, mechanischen Kontakt z.B. 4c und es ist dadurch die Bestätigung vorhanden, das der "Freibrennvorgang" des Kontaktes Erfolg hatte.
In der Diagrammzeile VI ist der Meßzeitpunkt für die Spannungsmessung mit Hilfe der Meßeinrichtung 8 bzw. der Strommessung am Halbleiterschalter 6 dargestellt. Zu erkennen ist hierbei, daß im Bereich des Zeitpunktes t₇ ein entsprechendes Meßfenster vorhanden ist, innerhalb dem die Messung stattfindet.

Fig. 3 zeigt wie Fig. 2 sechs Diagrammzeilen I bis VI, die sich von denen der Fig. 2 in der Diagrammzeile I, IV und V unterscheiden. Auch hierbei wird zum Zeitpunkt t₁ der Halbleiterschalter 6 leitend gesteuert (Diagrammzeile II), so daß ab diesem Zeitpunkt über den Verbraucher 3 (Fig. 1) Strom fließt, wie dies durch die Vertikalschraffur gem. Diagrammzeile I erkennbar ist.
Zum Zeitpunkt t₂ wird der mechanische Kontakt geschlossen, wobei an der Diagrammzeile IV erkennbar ist, daß trotz mechanischem Kontaktschluß eine Stromübernahme des Kontaktes z.B. wegen oxydierter Kontaktflächen, zu diesem Zeitpunkt nicht erfolgt. Beim nächsten Nulldurchgang der Netzwechselspannung zum Zeitpunkt t₃ wird der Halbleiterschalter nicht mehr angesteuert, um die Spannung über dem mechanischen Kontakt auf einen Wert ansteigen zu lassen, der zum Durchbrennen der Oxydschicht ausreicht.
Zwischen den Zeitpunkten t₅ und t₆ wird der Halbleiterschalter kurz angesteuert (Diagrammzeile II), um zu überprüfen, ob eine Stromübernahme des mechanischen Kontaktes erfolgt ist. Die Überprüfung erfolgt wiederum durch Messung der Gate-Kathoden-Spannung am Halbleiterschalter entsprechend der Diagrammzeile V. Zum Meßzeitpunkt t₇ wird eine Gate-Kathodenspannung (Diagrammzeile V) gemessen, und damit ist ein Stromfluß über den Halbleiterschalter 6 vorhanden. Der mechanische Kontakt hat demnach in der Ansteuerpause des Halbleiterschalters zwischen den Zeitpunkten t₃ und t₅ den Strom nicht übernommen. Dies läßt einen Rückschluß darauf zu, daß der Kontakt entweder durch die erhöhte Spannungsbelastung bei einer eventuell vorhandenen Oxydschicht nicht freigebrannt bzw. leitend gebrannt werden konnte oder aber daß der Kontakt anderweitig defekt ist.
Es wird in diesem Falle eine Störungsmeldung ausgegeben und der Stromkreis wird dann innerhalb der zulässigen Belastungszeit für den Halbleiterschalter, geöffnet.

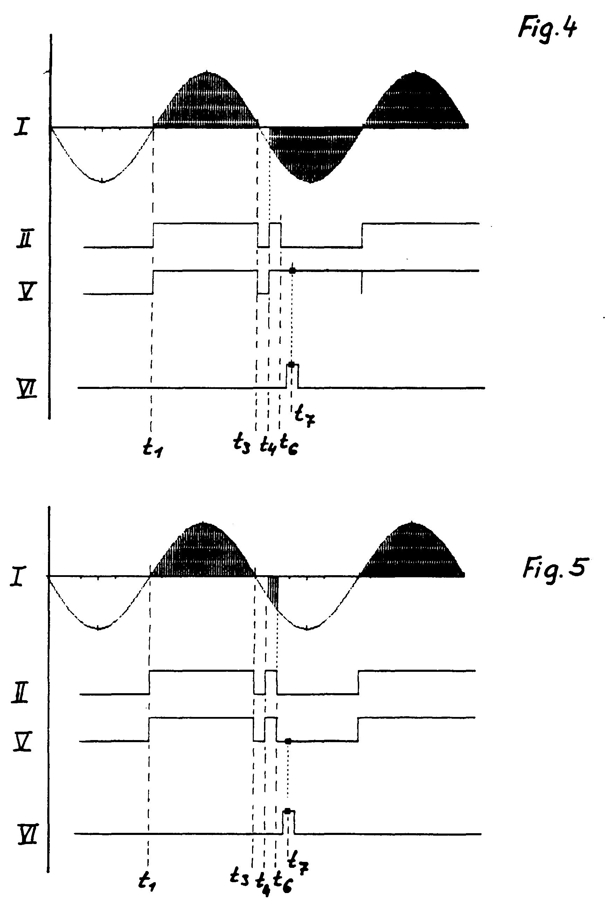

Die indirekte Strommessung am Halbleiterschalter mit Hilfe der Meßeinrichtung 8 kann auch zum Überprüfen der angeschlossenen Last auf Unterbrechung verwendet werden.
Zum Überprüfen der an eine Netzwechselspannung (Diagrammzeile I in Fig. 4) angeschlossenen Last wird der zum Halbleiterschalter 6 parallel geschaltete, mechanische Kontakt geöffnet, so daß der Stromfluß ausschließlich über den Halbleiterschalter erfolgt. Zum Lastüberprüfen wird nach einem Nulldurchgang im Zeitpunkt t₃ die Ansteuerung des Halbleiterschalters beispielsweise für 1 ms zwischen den Zeitpunkten t₃ und t₄ unterbrochen. Anschließend erfolgt wiederum eine kurze, zum Beispiel ebenfalls 1 ms dauernde Ansteuerung des Halbleiterschalters bis zum Zeitpunkt t₆ (vgl. Diagrammzeile II) und anschließend wird zum Meßzeitpunkt t₇ durch Messung der Gate-Kathodenspannung am Halbleiterschalter überprüft, ob dieser Strom führt oder nicht. In dem in Fig. 4 gezeigten Diagramm ist auch in der Ansteuerpause des Halbleiterschalters nach dem Zeitpunkt t₆ zwischen Gate und Kathode eine Spannung zu messen und es ist damit ein Stromfluß über den Halbleiterschalter vorhanden. Da die Meßunterbrechungen nur sehr kurz sind, kann eine Lastüberprüfung in vergleichsweise kurzen Abständen vorgenommen werden, ohne daß dies störend in Erscheinung tritt. Andererseits kann dadurch rechtzeitig bei Lastunterbrechung reagiert werden. In Fig. 5 ist eine solche Betriebssituation bei Lastunterbrechung erkennbar. Nachdem der Halbleiterschalter zwichen den Zeitpunkten t₁ und t₃ leitend gesteuert wird (Diagrammzeile II) erfolgt wiederum eine kurze Ansteuerpause und danach ein kurzes Ansteuern des Halbleiterschalters bis zum Zeitpunkt t₆. Nach diesem Zeitpunkt erfolgt wiederum die Messung der Gate-Kathoden-Spannung am Halbleiterschalter wobei im vorliegenden Falle bei Lastunterbrechung und nicht angesteuertem Halbleiterschalter auch keine Gate-Kathoden-Spannung gemessen wird. Es fließt somit kein Laststrom über den Halbleiterschalter was darauf schließen läßt, daß eine Lastunterbrechung vorliegt.

## Patentansprüche

1. Verfahren zum Betreiben einer in einen Stromkreis geschalteten, elektrischen Last über Kontakte eines elektromagnetischen Schalters, zu dessen Kontakt(en) ein Halbleiterschalter parallel geschaltet ist, wobei beim Ein- und Ausschalten der Halbleiterschalter und beim Betrieb die Kontakte des elektromagnetischen Schalters leitend sind, **dadurch gekennzeichnet**, daß während des Betriebs bei geschlossenem Kontakt (4) des elektromagnetischen Schalters (5) zum Beseitigen eines durch einen gegebenenfalls erhöhten Kontaktübergangswiderstand verursachten erhöhten Spannungsabfalls über dem mechanischen Kontakt (4), die Ansteuerung des Halbleiterschalters (6) zumindest kurzzeitig unterbrochen und damit der Halbleiterschalter bei erhöhtem Kontaktübergangswiderstand gesperrt und dadurch die Spannung am mechanischen Kontakt (4) erhöht wird.

2. Verfahren nach Anspruch 1, dadurch gekennzeichnet, daß der Stromkreis (2) wechselstrombeaufschlagt ist und daß die Sperrphase des Halbleiterschalters (6) während des Betriebs bei geschlossenem Kontakt (4) des elektromagnetischen Schalters (5) mit einem Nulldurchgang der Wechselspannung gestartet und innerhalb einer Halbwelle, vorzugsweise einer viertel Netzhalbwelle durch Ansteuerung des Halbleiterschalters beendet wird.

3. Verfahren nach Anspruch 1 oder 2, dadurch gekennzeichnet, daß während des Betriebs bei gesperrtem Halbleiterschalter (6) der Strom innerhalb des Stromkreises (2) gemessen wird und daß nach dem Überschreiten eines vorgebbaren Stromes (Schwellwert) der Halbleiterschalter (6) leitend geschaltet wird.

4. Verfahren nach einem der Ansprüche 1 bis 3, dadurch gekennzeichnet, daß das zumindest kurzzeitig Sperren des Halbleiterschalters (6) während des Betriebs bei geschlossenem Kontakt (4) des elektromagnetischen Schalters (5) nach jedem Einschaltvorgang oder nach einer vorgebbaren Anzahl von Einschaltvorgängen vorgenommen wird.

5. Verfahren nach einem der Ansprüche 1 bis 4, dadurch gekennzeichnet, daß der Spannungsabfall über dem geschlossenen Kontakt (4) des elektromagnetischen Schalters (5) und dabei leitend geschaltetem Halbleiterschalter (6) während des Betriebs überwacht und bei Überschreiten eines vorgebbaren Wertes, der Halbleiterschalter (6) zumindest kurzzeitig gesperrt wird.

6. Verfahren nach einem der Ansprüche 1 bis 5, dadurch gekennzeichnet, daß bei gesperrtem Halbleiterschalter (6) der Spannungsabfall über dem geschlossenen Kontakt (4) des elektromagnetischen Schalters (5) nach einer vorgebbaren Zeit nach dem Sperren des Halbleiterschalters (6) gemessen und bei Überschreiten eines vorgebbaren Wertes, der Stromkreis (2) vorzugsweise unterbrochen und/oder eine Störungsmeldung abgegeben wird.

7. Verfahren nach einem der Ansprüche 1 bis 6, dadurch gekennzeichnet, daß die Ansteuerung des Halbleiterschalters (6) während des Betriebs bei geschlossenem Kontakt (4) des elektromagnetischen Schalters (5) zumindest kurzzeitig gesperrt wird und daß dieser Vorgang wiederholt wird, wenn der gemessene Spannungsabfall über dem geschlossenen Kontakt (4) des elektromagnetischen Schalters (5) bei gesperrtem Halbleiterschalter (6) während des Betriebs einen vorgebbaren Wert überschreitet oder wenn bei diesem Betriebszustand innerhalb des Stromkreises kein Strom fließt.

8. Verfahren nach einem der Ansprüche 1 bis 7, dadurch gekennzeichnet, daß bei mehreren, unabhängig voneinander aktivierbaren elektromagnetischen Schaltern (5,5a,5b,5c) mit jeweils zueinander parallel geschalteten Kontakten (4,4a,4b,4c), während des Betriebs bis auf einen der Kontakte alle übrigen Kontakte geöffnet und die Ansteuerung des Halbleiterschalter (6) zumindest kurzzeitig gesperrt wird und daß nacheinander alle Einzelkontakte bei jeweils geöffneten anderen Kontakten durch kurzzeitiges Sperren der Ansteuerung des Halbleiterschalters (6) belastet werden.

9. Verfahren insbesondere nach einem der Ansprüche 1 bis 8, dadurch gekennzeichnet, daß die Spannung zwischen Gate (9) und Kathode des Halbleiterschalters (6), insbesondere von Thyristoren, nach einer vorgebbaren Zeit nach dem Sperren des Halbleiterschalters (6) gemessen und bei Überschreiten eines vorgebbaren Wertes, der Stromkreis (2) vorzugsweise unterbrochen und/oder eine Störungsmeldung abgegeben wird.

10. Verfahren nach Anspruch 9, dadurch gekennzeichnet, daß der während des Betriebs gesperrte Halbleiterschalter (6) kurzzeitig angesteuert und leitend geschaltet wird und daß danach bei nicht mehr angesteuertem Halbleiterschalter die Spannung zwischen Gate und Kathode des Halbleiterschalters (6) gemessen wird.

11. Vorrichtung zum Betreiben einer elektrischen Last in einem Stromkreis, in dem sich wenigstens ein Kontakt eines elektromagnetischen Schalters befindet, zu dessen Kontakt ein Halbleiterschalter parallel geschaltet ist, wobei eine Ansteuerschaltung für den elektromagnetischen Schalter sowie den Halbleiterschalter vorgesehen ist, zur Durchführung des Verfahrens nach Anspruch 1 bis 10, **dadurch gekennzeichnet**, daß die Ansteuerschaltung eine Zeitschalteinrichtung aufweist zum zumindest kurzzeitigen Sperren des Halbleiterschalter (6) während des Betriebs bei geschlossenem Kontakt (4) des elektromagnetischen Schalters (5).

12. Vorrichtung nach Anspruch 11, dadurch gekennzeichnet, daß mehrere, voneinander unabhängig betätigbare elektromagnetische Schalter (5,5a,5b,5c) mit jeweils einem Kontakt (4,4a,4b,4c) vorgesehen sind, deren Kontakte zueinander parallel geschaltet sind.

13. Vorrichtung nach Anspruch 11 oder 12, dadurch gekennzeichnet, daß sie einen Stromsensor zur Messung des Stromes innerhalb des Stromkreises aufweist, der mit der Ansteuerschaltung und insbesondere mit deren Zeitschalteinrichtung zum Ansteuern des Halbleiterschalters verbunden ist.

14. Vorrichtung nach einem der Ansprüche 11 bis 13, dadurch gekennzeichnet, daß sie einen Spannungsmesser zur Messung der Spannung über dem jeweiligen Kontakt des elektromagnetischen Schalters aufweist, der mit der Ansteuerschaltung und insbesondere mit deren Zeitschalteinrichtung zum Ansteuern des Halbleiterschalters verbunden ist.

15. Vorrichtung nach einem der Ansprüche 11 bis 14, dadurch gekennzeichnet, daß sie einen Spannungsmesser (8) zur Messung der Spannung zwischen Gate und Kathode des Halbleiterschalters (6) aufweist, der mit der Ansteuerschaltung und insbesondere mit deren Zeitschalteinrichtung zum Ansteuern des Halbleiterschalters (6) verbunden ist.

16. Vorrichtung nach einem der Ansprüche 11 bis 15, dadurch gekennzeichnet, daß bei einem mit Wechselstrom betriebenen Verbraucher innerhalb des Stromkreises, als Halbleiterschalter wenigstens ein Triac, vorzugsweise wenigstens zwei antiparallel geschaltete Thyristoren vorgesehen sind.

17. Vorrichtung nach einem der Ansprüche 11 bis 16, dadurch gekennzeichnet, daß die Ansteuerschaltung einen Mikrocontroller (7) beinhaltet und daß dieser zur Auswertung der Meßwerte mit wenigstens einem Stromsensor und/oder wenigstens einem Spannungssensor verbunden ist.

18. Vorrichtung nach einem der Ansprüche 11 bis 17, dadurch gekennzeichnet, daß der Halbleiterschalter (6), der oder die elektromagnetischen Schalter (5,5a,5b,5c) die Ansteuer-und Auswerteschaltung (7) und dergleichen Baugruppen, gegebenenfalls in Verbindung mit einer Sanfteinschaltvorrichtung für induktive Lasten, in einer kompakten Baueinheit insbesondere als Hybridschalter zusammengefaßt sind.
